(19) Europäisches Patentamt
European Patent Office
Office européen des brevets

(11) **EP 4 546 006 A1**

(12) **EUROPEAN PATENT APPLICATION**

(43) Date of publication:
30.04.2025 Bulletin 2025/18

(21) Application number: 24207128.0

(22) Date of filing: 17.10.2024

(51) International Patent Classification (IPC):
*G01S 7/481* (2006.01) *H05K 9/00* (2006.01)

(52) Cooperative Patent Classification (CPC):
G01S 7/4813; H05K 9/0024; H05K 9/0049;
H05K 9/0058

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 25.10.2023 FR 2311593

(71) Applicant: STMicroelectronics International N.V.
1228 Plan-les-Ouates, Geneva (CH)

(72) Inventors:
• MAO, Yandong
  SHANGHAI, 200240 (CN)
• TEO, Tat Ming
  797463 SINGAPORE (SG)
• WILLIAMS, Fraser
  EDINBURGH, EH11 2BY (GB)
• HALLIDAY, William
  EDINBURGH, EH12 8EX (GB)

(74) Representative: Cabinet Beaumont
4, Place Robert Schuman
B.P. 1529
38025 Grenoble Cedex 1 (FR)

(54) **OPTICAL SENSOR MODULE**

(57) The present disclosure relates to a substrate assembly (100) for an optical sensor module, the substrate assembly comprising:
- a light-emitting device (110) mounted on a first region (101R) of a substrate (101);
- a metal shielding assembly comprising a first metal shielding (130) assembled to the substrate over the first region;
wherein the first metal shielding comprises a first opening (131) providing an optical path for light emitted by the light-emitting device, the first opening being dimensioned such that said light-emitting device can be inserted through said first opening inside said first metal shielding.

FIG.1A

**Description**

Technical field

The present disclosure relates generally to optical sensors, in particular optical sensor modules.

Background art

Optical sensors, such as proximity sensors, may be used to detect the presence of nearby objects. Optical sensors are able to do so without physically touching the object. Some types of optical sensors, such as those utilized in optical ranging devices or time of flight sensors, may be used to determine the actual distance to such nearby objects. Optical sensors may be utilized in various electronic devices, such as cameras, phones, including smartphones, smartwatches, tablets, vehicles, machinery, and other devices for detecting the presence of and/or distance to nearby objects. After detecting the presence of the nearby object, the electronic device may be configured to perform a function, such as move a mechanical feature to a secure position, transmit an alarm signal, couple or uncouple an electrical communication, or any other desired function.

Optical sensors typically include components, such as a light-emitting device, a light-receiving sensor, and generally a processing device for processing signals received from the light-receiving sensor. The components of the optical sensor may be formed on a substrate, and a cap may be bonded to the substrate over the components, for example to protect them from damage, thereby forming an optical sensor module, also called optical sensor package. The cap is generally formed with a first cap opening located over the light-emitting device and a second cap opening located over the light-receiving sensor.

Generally described, the light-emitting device emits a light signal, for example through the first cap opening. If an object is outside, and close enough to, the optical sensor module, the light signal may be reflected by the object towards the light-receiving sensor, for example through the second cap opening. The light-receiving sensor may then generate an electrical signal indicative of the received light signal, which may be transmitted to the processing device for processing said received light signal, for example to determine the presence of, and/or distance to, the proximate object.

There is a need for improving optical sensor modules, in particular to address electronic magnetic interference (EMI) issues between an optical sensor module and another electronic device, for example an electronic device that incorporates the optical sensor module, which may be designated as a host device, in particular for optical sensors used in consumer electronics. For example, the host device may be a camera, a smartphone, a smartwatch, a tablet, or another device for which it may be useful to detect the presence of and/or distance to nearby objects.

Summary of Invention

One embodiment addresses all or some of the drawbacks of known optical sensor modules.

One embodiment provides a substrate assembly for an optical sensor module, the substrate assembly comprising:

- a light-emitting device mounted on a first region of a substrate;
- a metal shielding assembly comprising a first metal shielding assembled to the substrate over the first region;

wherein the first metal shielding comprises a first opening providing an optical path for light emitted by the light-emitting device, the first opening being dimensioned such that said light-emitting device can be inserted through said first opening inside said first metal shielding.

In one embodiment, the first metal shielding is dimensioned to surround and at least partially cover the light-emitting device, the first metal shielding for example comprising a sidewall joined by a top wall, the top wall including the first opening.

In one embodiment, the light-emitting device comprises:

- at least a light source, the first opening providing an optical path for light emitted by the at least one light source and being dimensioned such that said at least one light source can be inserted inside said first metal shield and mounted onto the substrate through said first opening; and, optionally,
- a photodiode configured to monitor the light-emitting device, the first opening further providing an optical path for light transmitted to the photodiode, and being further dimensioned such that said photodiode can be inserted inside said first metal shield and mounted onto the substrate through said first opening.

In one embodiment, the substrate assembly further comprises a driver mounted on the first region of the substrate, the driver being configured for controlling the light-emitting device.

In one embodiment, the first opening extends over the driver.

In one embodiment, the first metal shielding is electrically coupled to the substrate, for example to a ground trace of the substrate.

In one embodiment, the metal shielding assembly further comprises a second metal shielding assembled to the first metal shielding and at least partially covering the first opening, the second metal shielding comprising at least a second opening allowing the passage of light emitted by, and/or transmitted to, the light-emitting device, the second metal shielding being for example electrically coupled to, or in contact with, the first metal shielding.

In one embodiment, the second metal shielding includes a recessed part extending inside the metal shielding assembly.

In one embodiment, the second metal shielding seals the first opening.

In one embodiment, the second metal shielding at least partially closes the first metal shielding.

In one embodiment, the metal shielding assembly comprises an absorber layer positioned on an inside surface of said metal shielding assembly that faces the light-emitting device, for example on an inside surface of the first metal shielding that faces the light-emitting device.

In one embodiment, the substrate assembly further comprises a glass including an electrically conductive trace assembled to the first metal shielding over the first opening, the conductive trace being for example electrically coupled to, or in contact with, the first metal shielding, for example coupled to a ground trace of the substrate through the first metal shielding.

In one embodiment, the metal of the metal shielding assembly is selected to reflect and/or absorb electromagnetic waves, for example the metal is copper, a copper alloy, a stainless steel, or any electrically conductive material that also has relative magnetic permeability higher than 1.

One embodiment provides an optical sensor module comprising a substrate assembly as the substrate assemblies described hereabove, and a module cap assembled to the substrate and adapted to at least partially cover the metal shielding assembly and components which are mounted on the substrate.

One embodiment provides a method of fabricating a substrate assembly for an optical sensor module, the method comprising:

- assembling a first metal shielding to a substrate over a first region of said substrate, the first metal shielding comprising a first opening providing an optical path for light emitted by a light-emitting device to be mounted on the first region; and
- mounting the light-emitting device to the first region through the first opening.

In one embodiment, the method further comprises, after the mounting step, assembling a glass including an electrically conductive trace to the first metal shielding over the first opening, the conductive trace being for example electrically coupled to, or brought into contact with, the first metal shielding.

In one embodiment, the method further comprises, after the mounting step, assembling a second metal shielding to the first metal shielding in order to at least partially cover the first opening, the second metal shielding comprising at least a second opening allowing the passage of light emitted by, and/or transmitted to, the light-emitting device, the second metal shielding being for example electrically coupled to, or brought into contact with, the first metal shielding.

## Brief description of drawings

The foregoing features and advantages, as well as others, will be described in detail in the following description of specific embodiments given by way of illustration and not limitation with reference to the accompanying drawings, in which:

Figure 1A is a 3-dimensional view of a substrate assembly for an optical sensor module according to an embodiment;

Figure 1B is a cross-section view of the substrate assembly of Figure 1A;

Figure 2A, Figure 2B, Figure 2C and Figure 2D are top and 3-dimensional views illustrating an example of method of fabricating the substrate assembly of Figures 1A and 1B;

Figure 3A is a 3-dimensional view of a substrate assembly for an optical sensor module according to another embodiment;

Figure 3B is a sectioned 3-dimensional view showing a detail of the substrate assembly of Figure 3A;

Figure 4 is a 3-dimensional view illustrating a variant of the method of Figures 2A to 2D for fabricating the substrate assembly of Figures 3A and 3B;

Figure 5A is a 3-dimensional view of a substrate assembly for an optical sensor module according to another embodiment;

Figure 5B is a sectioned 3-dimensional view showing a detail of the substrate assembly of Figure 5A;

Figure 5C is a 3-dimensional view of a variant of the substrate assembly of Figure 5A;

Figure 6A and Figure 6B are top and 3-dimensional views illustrating a variant of the method of Figures 2A to 2D for fabricating the substrate assembly of Figures 5A to 5C;

Figure 7 is a 3-dimensional view of a substrate assembly for an optical sensor module according to another embodiment; and

Figure 8A and Figure 8B are top and 3-dimensional views illustrating a variant of the method of Figures 2A to 2D for fabricating the substrate assembly of Figure 7.

Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, all the components of a substrate assembly have not been detailed, the described embodiments being compatible with the usual substrate assemblies in optical sensor modules. For example, the light-emitting device, the light-receiving sensor, and other components of an optical sensor, such as a processing device or circuit, have not been detailed. Similarly, all the components of an optical sensor module have not been detailed, the described embodiments being compatible with the usual optical sensor modules.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures, or to a substrate assembly or an optical sensor module as orientated during normal use.

Unless specified otherwise, the expressions "around", "approximately", "substantially" and "in the order of" signify within 10 %, and preferably within 5 %.

In the following disclosure, unless indicated otherwise, when reference is made to a glass, this includes an element made of a material which is relatively transparent to light at the wavelengths used, for example has a transmission rate of 90 percent or more for these wavelengths. This includes, without being limited to, a glass material or plastic material. The glass may be formed of a solid single material, or may be formed by assembling multiple materials, in which case only part of the glass may be in a transparent material. The glass may comprise, or consist in, a lens or a plurality of lenses, and/or an optical filter.

In the following disclosure, unless indicated otherwise, when reference is made to a conductive element, reference is made to an electrically conductive element.

In the present disclosure, unless indicated otherwise, when reference is made to a component, reference is made to an electronic component.

The term "optical sensor module" includes, without being limited to, a proximity sensor module, a time of flight (ToF) module, an ambient light sensor (ALS) module, a 3D Lidar module, and/or a camera module. The term optical sensor module also includes an optical sensor module with combined functions, for example a combination of at least two of the above-mentioned modules, or other functions, for example a combination of a proximity detector module with a floodlight and/or a dot projector.

The embodiments relate to optical sensor modules. An optical sensor typically includes a light-emitting device, comprising for example a light emitting diode (LED), or a laser such as a vertical cavity surface emitting laser (VCSEL), and a light-receiving sensor comprising for example a photodiode or a plurality of photodiodes. An optical sensor generally also includes a processing device or circuit for processing signals received from the light-receiving sensor. The light-emitting device and the light-receiving sensor may be formed on a substrate, and a module cap may be assembled to the substrate over the light-emitting device and the light-receiving sensor, thereby forming an optical sensor module, also called optical sensor package. The light emitting device may comprise a plurality of light sources, for example a plurality of VCSELs.

The term "substrate assembly" corresponds to a subassembly of an optical sensor module. The substrate assembly generally comprises a substrate and components mounted on the substrate, such as a light-emitting device and a light-receiving sensor. The module cap of the optical sensor module is generally assembled to the substrate over the components mounted on the substrate.

The optical sensor module may be affected by electromagnetic interferences (EMI) with another electronic device.

For example, when the optical sensor module is included in an electronic device (host device), electromagnetic interferences (EMI) may occur between the optical sensor module and the host device. The host device may be a camera, a phone, for example a smartphone, a smartwatch, a tablet, a vehicle, or another device for which it may be useful to detect the presence of and/or distance to nearby objects.

The electromagnetic interferences between the optical sensor module and the host device may comprise:

- electromagnetic waves emitted by components of the optical sensor module which may affect components of the host device; and/or
- electromagnetic waves emitted by the host device which may affect the performance of the optical sensor module.

For example, a potential source of electromagnetic waves emitted by the optical sensor module may come from the light-emitting device, for example from a light source of the light-emitting device, such as a VCSEL, from a driver such as a laser driver, from inductors or even from conductive wires (wire bonds).

In addition, environments, such as environments having huge electromagnetic waves, for example data centres, may also interfere with components of the optical sensor module and affect its performance.

In some applications, controlling the effect of EMI is important, for example protecting electronic components and circuits from EMI.

One solution to address the electromagnetic interference issues is to add a single metal shield over the electromagnetically sensitive components.

However, a single metal shield can have a certain number of drawbacks. A single metal shield may need a large opening for optical path. Depending on the method used, the fabrication of a metal shield may introduce a large number of steps, for example assembly steps, which induce high costs, and which may alter or affect the functioning of some components of the optical sensor module. The fabrication may also introduce slots or gaps in the metal shield, for example for the assembly or the cleaning of surface-mount technology (SMT) components, which can allow electromagnetic waves to pass through, which may be source of EMI leakage. Optical paths may also be affected by a single metal shield, leading to an increased or uncontrolled level of external crosstalk in the optical sensor module.

The inventors propose an optical sensor module making it possible to overcome all or part of the aforementioned drawbacks, in particular to address the electromagnetic interference issues, using an efficient and simple EMI protection capable of decreasing EMI leakage and/or increasing EMI shielding, which can avoid altering the functioning of some components of the optical sensor module, and preferably which can avoid increasing the footprint of the optical sensor module, and complexifying the fabrication method.

It may also be desirable that the optical sensor module can manage the electromagnetic interferences through an opening of the EMI protection.

Embodiments of substrate assemblies for optical sensor modules will be described below. These embodiments are non-limiting and various variants will appear to the person skilled in the art from the indications of the present description.

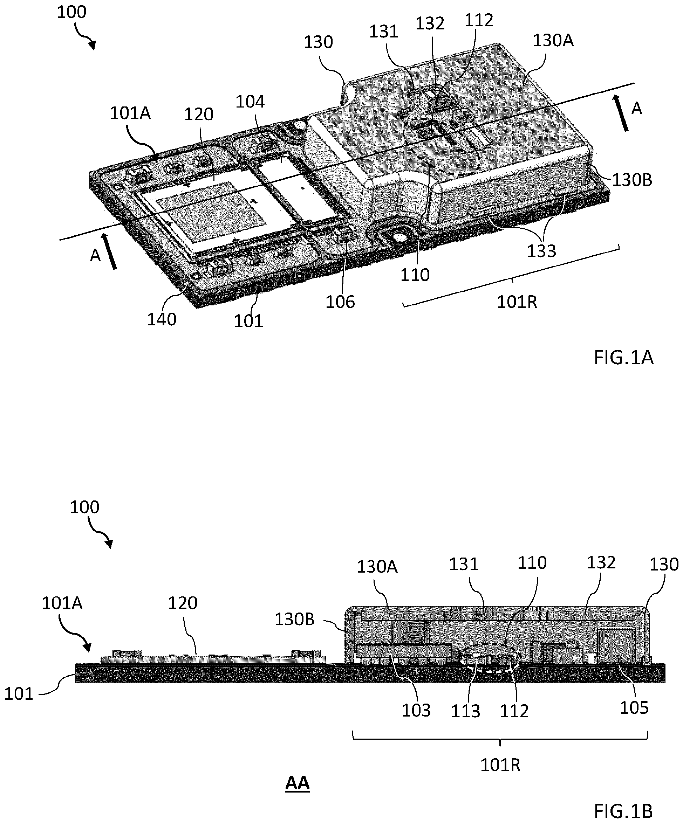

Figure 1A is a 3-dimensional view of a substrate assembly 100 for an optical sensor module according to an embodiment. Figure 1B is a cross-section view of the substrate assembly 100 of Figure 1A. The cross-section view of Figure 1B shows the substrate assembly 100 cut in the AA direction shown in Figure 1A.

The substrate assembly 100 comprises a plurality of components mounted on a top surface 101A of a substrate 101.

The substrate assembly 100 comprises a light-emitting device 110, for example comprising a LED such as an infrared LED, and/or a laser such as a VCSEL or an Edge Emitting Laser (EEL), and a light-receiving sensor 120, for example comprising a photodiode or a plurality of photodiodes, such as SPAD(s), the light-emitting device 110 and the light-receiving sensor 120 being mounted on the top surface 101A of a substrate 101. The light-emitting device 110 may comprise a plurality of light sources.

The substrate 101 may be a printed circuit board (PCB).

The light-emitting device 110 is configured to emit light signals at a particular frequency or frequency range, and the light-receiving sensor 120 is adapted to detect the emitted light signals in return, for example reflected by an object. In one embodiment, the light-emitting device 110 is configured to emit infrared (IR) light signals, and the light-receiving sensor 120 is adapted to detect the IR light signals in return, for example reflected by an object.

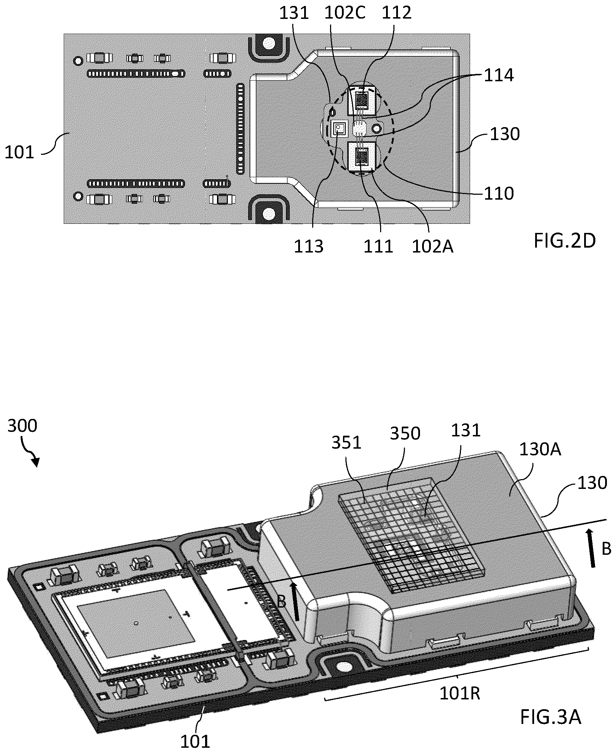

For example, the light-emitting device 110 may comprise first and second light sources 111, 112 each mounted on the top surface 101A of the substrate 101, as can be seen in Figure 2D described hereafter. Only the second light source 112 is shown in Figures 1A and 1B. The first and second light sources 111, 112 are for example first and second VCSELs. The light-emitting device 110 may further include a photodiode 113 mounted on the top surface 101A of the substrate 101. The photodiode 113 may be dedicated to monitor the light sources.

In a variant, the light-emitting device may comprise only one light source. In another variant, the light-emitting device may comprise more than two light sources.

In a variant, the light-emitting device may not comprise a photodiode, and/or comprise another component to monitor the light source(s). In another variant, the light-emitting device may comprise more than one photodiode.

The light-emitting device 110 may be electrically coupled to the light-receiving sensor 120, for example through the substrate 101.

The substrate assembly 100 may comprise a driver 103, for example a laser driver, configured for controlling the light-emitting device 110, and a processing circuit 104 for processing light signals emitted by the light-emitting device 110 and received by the light-receiving sensor 120. The driver 103 and the processing circuit 104 may be mounted on the top surface 101A of the substrate 101. The driver 103 is for example mounted on the substrate 101 using a ball grid array technique.

The substrate assembly 100 may include other electrical circuits, or components, such as inductors 105 or other surface-mount technology (SMT) components 106 which are also mounted on the top surface 101A of the substrate 101. The other SMT components 106 may comprise resistors. Further SMT components may comprise capacitors.

The light-emitting device 110, including the light sources 111, 112 and the photodiode 113, the driver 103, the inductors 105 and some of the other SMT components 106 are mounted on a first region 101R of the substrate 101.

The substrate assembly 100 further comprises a first metal shielding 130 mounted over the first region 101R of the substrate 101. The first metal shielding 130 is preferably shaped and dimensioned to surround and at least partially cover the components, at least the light-emitting device 110, the driver 103, and the inductors 105, which are mounted on the first region 101R. Therefore, the first metal shielding 130 advantageously encircles potential sources of electromagnetic waves emitted by components of the substrate assembly.

The first metal shielding 130 has sidewalls 130B joined to a top wall 130A.

The first metal shielding 130 may be named as, or comprised in, a metal shielding assembly.

The first metal shielding 130 is electrically coupled to the substrate 101, preferably to a ground trace, or a ground rail, of the substrate 101 to further improve the effectiveness of EMI protection, for example for effective absorption of electromagnetic waves.

The first metal shielding 130 includes a first opening 131 formed in the top wall 130A, this first opening providing an optical path for light emitted by, and optionally transmitted to, the light-emitting device 110, that is, allowing the passage of light emitted by, and optionally transmitted to, the light-emitting device.

The first opening 131 is also shaped and dimensioned such that the light-emitting device 110, that is the light source(s), and optionally the photodiode, can be inserted vertically through this first opening inside the first metal shielding 130, in order to be mounted onto the substrate 101. The dimensions of the first opening 131 may include a sufficient gap for mounting these components onto the substrate 101 through this first opening, depending on the surface-mount method that is used.

For example, as illustrated, the area of the first opening 131 may be, in a first plane parallel to the plane of the substrate 101, at least equal to the areas of the light source (s), and optionally of the photodiode, in the first plane, for example adjusted to the areas of the light source(s), and optionally of the photodiode. This allows limiting the area of the first opening to the strictly necessary for the mounting, to avoid increasing EMI leakage.

The area of the first opening 131 may be a trade-off between the EMI protection and the mounting of the light source(s), and optionally of the photodiode, onto the substrate 101 through this first opening.

The first opening 131 is configured for mounting the light source(s), and optionally the photodiode, on the substrate 101, after having assembled the first metal shielding 130 on the substrate, for example avoiding affecting or altering the light-emitting device 110 during the assembly of the first metal shielding 130 on the substrate 101. For example, this can avoid contaminating the light-emitting device 110 during an assembling step such as a reflow step.

In a variant, instead of a single first opening, it may be a plurality of first openings which are not necessarily joined to each other.

The metal of the first metal shielding 130 is preferably selected to reflect and/or absorb electromagnetic waves generated by the components mounted on the first region 101R to prevent the electromagnetic waves from exiting the substrate assembly 100, and also from the optical sensor module, and for example from affecting a host device. The metal of the first metal shielding 130 may also be selected to reflect and/or absorb electromagnetic waves generated by another electronic device, such as a host device, or electromagnetic waves coming from the environment, to prevent the electromagnetic waves from affecting the performance of the components of the optical sensor module which are mounted on the first region. The metal of the first metal shielding is for example copper, or a copper alloy, a stainless steel, or any electrically conductive material that also has relative magnetic permeability higher than 1.

The first metal shielding 130 further includes an absorber layer 132, or EMI absorber layer, located on the inside surface of the top wall 130A of this first metal shielding. The absorber layer 132 faces the light-emitting device 110. The absorber layer comprises a material suitable for absorbing electromagnetic waves, for example EMI absorber materials commercialized by Parker Chomerics company under CHO-MUTE™ name, EMI absorbers commercialized by Doosung Corp company under IDSOB, IDCIM names, or EMI absorbers commercialized by Laird company. The absorber layer 132 has an opening which faces the first opening 131 and which has preferably an area equal or higher than the area of the first opening.

Although not shown in Figures 1A and 1B, the optical sensor module generally comprises a module cap assembled to the substrate assembly 100 and adapted to at least partially enclose, or cover, components which are mounted on the substrate, at least the light-emitting device and the light-receiving sensor. The module cap also covers the metal shielding assembly. At least partially means that all the components may be not covered. For example, a module cap generally comprises a first cap opening located over the light-emitting device and a second cap opening located over the light-receiving sensor. The first cap opening preferably faces the first opening of the first metal shielding, and has an area which is preferably equal or higher than the area of this first opening. The module cap may be substantially opaque to light at the wavelengths used. The module cap may be mounted on an opaque adhesive 140, shown in Figure 1A, which is attached to the substrate 101. The module cap may include a separation wall between the light-emitting device and the light-receiving sensor, to form an optical isolator for substantially preventing the internal propagation of light beams between the light-emitting device and the light-receiving sensor.

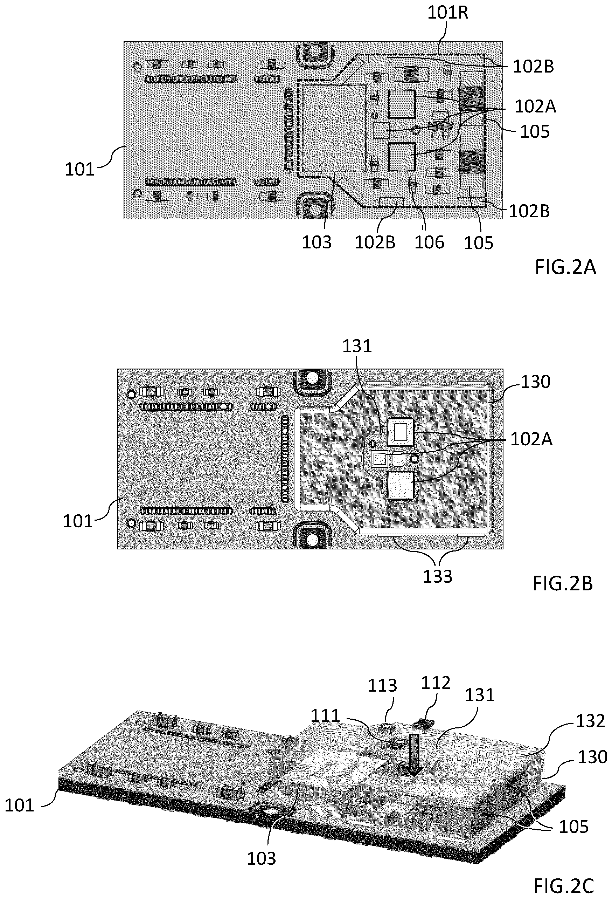

Figure 2A, Figure 2B, Figure 2C and Figure 2D are top and 3-dimensional views illustrating an example of method of fabricating the substrate assembly 100 of Figures 1A and 1B.

Figure 2A is a top view of a starting structure comprising the substrate 101. The inductors 105 and other SMT components 106 are mounted on the first region 101R of the substrate 101. The driver 103 may also be already mounted on the first region 101R using a surface-mount assembling technique such as a ball grid array technique.

The first region 101R includes first conductive pads 102A adapted to receive and connect the light sources 111, 112 and the photodiode 113, and second conductive pads 102B corresponding, or connected, to the ground trace of the substrate 101.

Figure 2B is a top view of a structure obtained by assembling the first metal shielding 130, including the absorber layer 132, on the substrate 101.

The assembly of the first metal shielding 130 on the substrate 101 may be performed using a surface-mount technique, for example by forming spots of a solder paste on the second conductive pads 102B and bringing the first metal shielding 130 into contact with the solder spots, and then reflowing the solder paste to form solder joints 133. Other soldering techniques may be used. Alternately, the assembly may be performed using a conductive adhesive, or using other electrical coupling means between the first metal shielding and the ground trace of the substrate.

At the end of this assembling step, the first metal shielding 130 is attached to the substrate 101, and brought electrically into contact with the second conductive pads 102B, and thus with the ground trace.

Figure 2C is a 3-dimensional view of a structure during the inserting of the first and second light sources 111, 112 and of the photodiode 113 inside the first metal shielding 130 through the first opening 131.

The first and second light sources 111, 112 and the photodiode 113 are then mounted on the substrate 101, for example using a die attach process.

Figure 2D is a top view of a structure obtained after having electrically connected each of the first and second light sources 111, 112, and possibly the photodiode 113, to the substrate 101, through the first opening 131, for example using a wire bonding technique. As an example, shown in Figure 2D, conductive wires 114 connect each light source to a third conductive pad 102C of the substrate 101, but other techniques may be used to connect the light sources to the substrate.

In certain embodiments, as illustrated in Figure 2D, the first conductive pads 102A on which the light source(s), and optionally the photodiode, are to be positioned are entirely visible through the first opening 131 in plan view. In other words, a projection of the first opening 131 vertically on the substrate 101 entirely contains a footprint of the first conductive pads 102A on the substrate 101. This implies that, advantageously, the light source(s), and optionally the photodiode, can be lowered directly vertically through the first opening 131 and onto the substrate 101 in their final locations, and can be wire-bonded to these first conductive pads.

The light-receiving sensor 120 may then be mounted on the substrate 101, as well as other components such as the processing circuit 104.

Therefore, components of the substrate assembly 100, such as the light emitting device 110, the driver 103, the inductors 105 or even the conductive wires 114, which may be electromagnetic sources, are at least partially encircled, or contained, inside the first metal shielding 130. The first metal shielding 130 may allow absorbing and reflecting electromagnetic waves emitted by these components. The first metal shielding 130 may also allow protecting these components from electromagnetic waves provided from the outside of the first metal shielding or even from the outside of the optical sensor module. In addition, the absorber layer 132 of the first metal shielding 130 allows better absorbing the electromagnetic waves emitted by the electromagnetic sources, for example emitted by the light-emitting device 110, the driver 103, the inductors 105 and/or the conductive wires 114, lowering the EMI power intensity inside this first metal shielding, and thus the EMI leakage. Thus, the first metal shielding 130 including the absorber layer 132 allows lowering EMI leakage, for example from through the first opening 131, thus providing an efficient EMI protection.

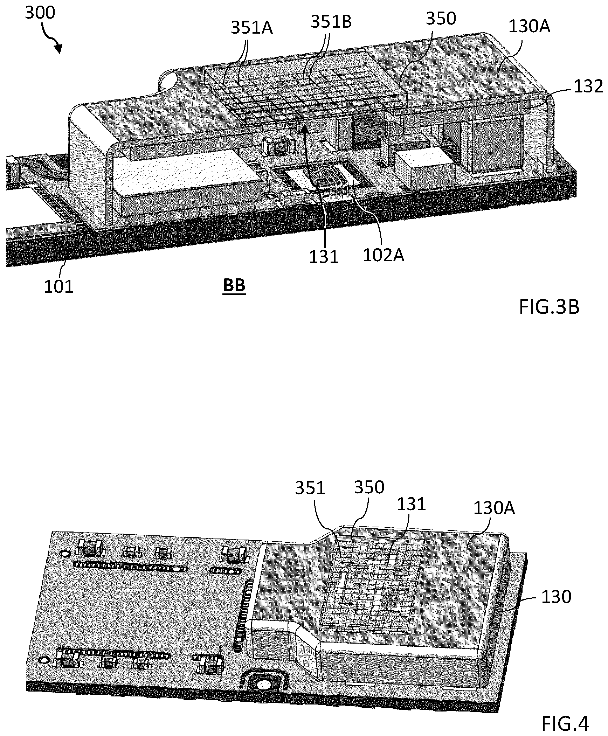

Figure 3A is a 3-dimensional view of a substrate assembly 300 for an optical sensor module according to another embodiment. Figure 3B is a sectioned 3-dimensional view showing a detail of the substrate assembly 300 of Figure 3A. The sectioned 3-dimensional view of Figure 3B shows a detail of the substrate assembly 300 cut to a little less than half its width in the BB direction shown in Figure 3A, and makes it easier to see the different components of the substrate assembly located under the first metal shielding.

The substrate assembly 300 of Figures 3A and 3B mainly differs from that of Figures 1A and 1B in that the first opening 131 of the first metal shielding 130 is covered by a glass 350 including an electrically conductive trace 351. The conductive trace 351 in the glass 350 allows managing EMI in the first opening 131, for example by providing EMI reflection in said first opening, thus limiting EMI leakage and providing an efficient EMI protection, even with a large first opening.

The first metal shielding 130 may be named as, or included in, a metal shielding assembly.

The conductive trace material may be one or a plurality of the following materials: copper (Cu), aluminum (Al), indium-tin oxide (ITO), tungsten (W), titanium (Ti), gold (Au).

The conductive trace 351 shown in Figures 3A and 3B forms a mesh, or grid, having a plurality of substantially parallel first linear portions 351A in a first direction of the glass plane and second linear portions 351B in a second direction of the glass plane. The first and second directions are for example substantially perpendicular to each other. Two adjacent first linear portions are separated by a first distance, or first pitch, in the first direction and two adjacent second linear portions are separated by a second distance, or second pitch, in the second direction. Each of the first and the second distances is for example smaller than, or equal to, a fraction of the wavelength λ, as defined above.

Each linear portion of the conductive trace 351 may be a thin portion, for example having a thickness less than 100 nanometers. The first pitch between the first linear portions 351A, respectively the second pitch between the second linear portions 351B, can be determined according to the frequencies of the EMI to be managed. For example, the higher frequency, the lower the pitch can be.

Each pitch is for example smaller than the wavelength λ of the electromagnetic signal to be attenuated, and is for example a fraction of the wavelength λ, where λ is equal to:

$$\lambda = {^v}\!/_f$$

where v is the speed of light and f is the frequency of the electromagnetic wave chosen to be attenuated.

The thickness and the pitches of the conductive trace 351 may be a trade-off between the EMI protection function and the optical transmittivity of the glass 350. For example, the conductive trace could be thicker and/or the pitches lower where the conductive trace is not likely to affect the desired quality of light transmission, alternatively the conductive trace could be thinner and/or the pitches higher where the conductive trace is likely to affect the desired quality of light transmission.

The mesh is an example of pattern which can be used to form the conductive trace. Different patterns of the conductive trace may be contemplated by the person skilled in the art. For example, the conductive trace may comprise portions which are not be perpendicular to each other, for example may comprise zig-zag patterns, allowing the distance between the patterns to be minimized.

Advantageously, the conductive trace 351 is grounded, in order to provide additional EMI protection. For example, the conductive trace 351 is electrically coupled to, for example in contact with, the first metal shielding 130, and is coupled to the ground trace of the substrate 101 through the first metal shielding 130.

Examples of conductive trace are described in more detail in the French patent application number 2311561, filed on October 25, 2023 in the name of STMICROELECTRONICS INTERNATIONAL N.V. (law firm reference being B22689), and in the European patent application claiming the priority of the French patent application number 2311561, which are hereby incorporated by reference to the maximum extent allowable by law.

The other features of the substrate assembly 300 of Figures 3A and 3B may be similar to those of the substrate assembly 100 of Figures 1A and 1B. The variants described in relation with the substrate assembly 100 of Figures 1A and 1B may also apply to the substrate assembly 300 of Figures 3A and 3B. The optical sensor module of figures 3A and 3B generally comprises a module cap assembled to the substrate assembly 300, similarly to the optical sensor module of figures 1A and 1B.

Figure 3B shows the EMI absorber layer 132 located on the inside surface of the top wall 130A of the first metal shielding 130. In a variant, the substrate assembly 300 of Figures 3A and 3B may not include an EMI absorber layer.

The first opening 131 shown in Figures 3A and 3B has substantially the same area as the first opening of Figures 1A and 1B, but this is not limiting.

Figure 4 is a 3-dimensional view illustrating a variant of the method of Figures 2A to 2D for fabricating the substrate assembly 300 of Figures 3A and 3B.

Starting from the structure of Figure 2D, the glass 350 with the conductive trace 351 is positioned on the top wall 130A of the first metal shielding 130 in order to cover the first opening 131, and such that the conductive trace 351 may come into contact with the first metal shielding 130. The conductive trace 351 is then assembled to the top wall 130A, for example using an electrically conductive adhesive, such as a conductive epoxy. Preferably, this assembly ensures an electrical connection between the conductive trace 351 and the first metal shielding 130.

The light-receiving sensor 120 may then be mounted on the substrate 101, as well as other components such as the processing circuit 104.

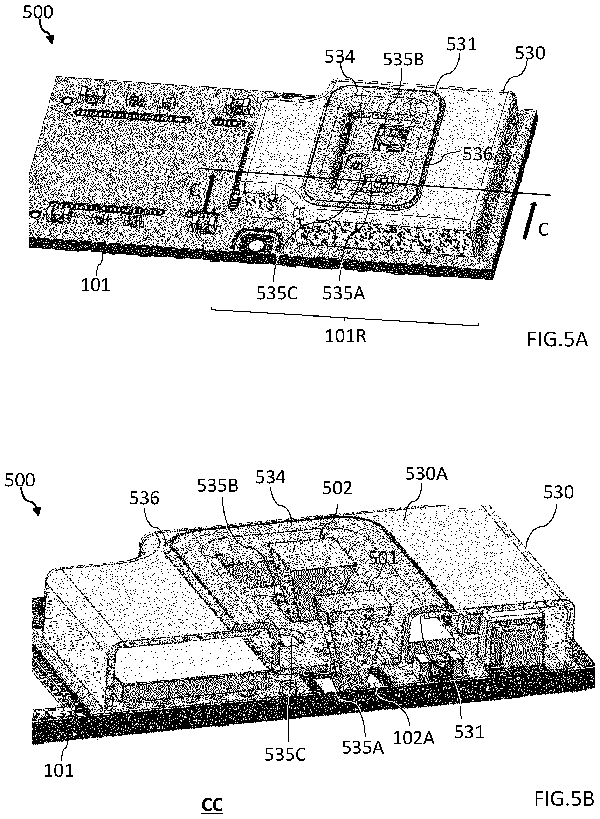

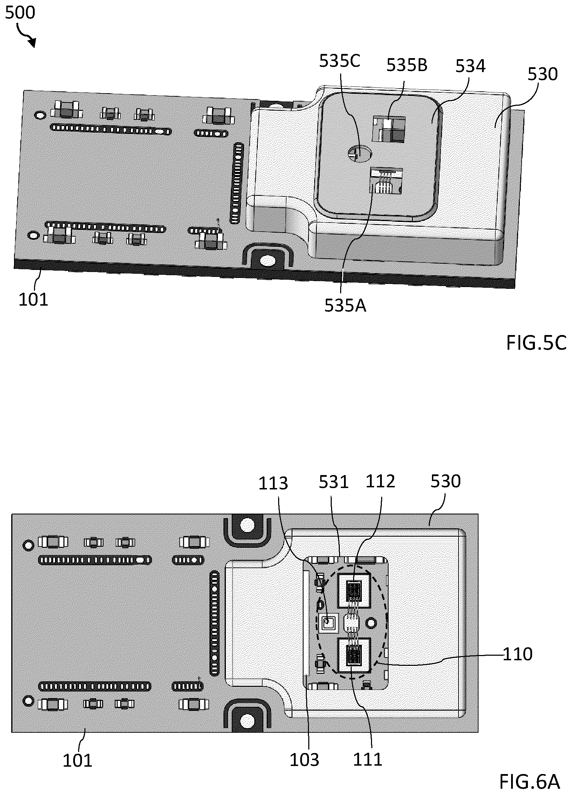

Figure 5A is a 3-dimensional view of a substrate assembly 500 for an optical sensor module according to another embodiment. Figure 5B is a sectioned 3-dimensional view showing a detail of the substrate assembly 500 of Figure 5A. Figure 5C is a 3-dimensional view of a variant of the substrate assembly of Figure 5A. The sectioned 3-dimensional view of Figure 5B shows a detail of the substrate assembly 500 cut to about a third of its width in the CC direction shown in Figure 5A, and makes it easier to see the different components of the substrate assembly located under the first and second metal shielding.

The substrate assembly 500 of Figures 5A to 5C mainly differs from that of Figures 1A and 1B in that the first opening 531 of the first metal shielding 530 is not necessarily adjusted to the dimensions of the light source(s), and optionally of the photodiode, for their mounting on the substrate 101, including the mounting gaps. In other words, a trade-off between the EMI protection and the mounting through the first opening 531 is not necessarily searched, and the first opening 531 can have a large area. In addition, the substrate assembly 500 further comprises a second metal shielding 534 adapted to be assembled to the first metal shielding 530 over the first opening 531 once the light-emitting device 110 is mounted and electrically connected to the substrate 101. The shape and dimensions of the second metal shielding 534 are preferably adapted to cover the first opening 531. For example, the second metal shielding 534 is adapted to seal the first opening 531.

The first metal shielding 530 and the second metal shielding 534 form a metal shielding assembly.

The metal of the second metal shielding 534 is preferably selected to reflect and/or absorb:

- electromagnetic waves generated by the components mounted on the first region 101R to prevent the electromagnetic waves from exiting the substrate assembly 100, and also from the optical sensor module, and for example from affecting a host device;
- electromagnetic waves generated by another electronic device, such as a host device, or electromagnetic waves coming from the environment, to prevent the electromagnetic waves from affecting the performance of the components of the optical sensor module which are mounted on the first region.

The metal of the second metal shielding may be the same as the metal of the first metal shielding.

The metal shielding assembly advantageously encircles potential sources of electromagnetic waves emitted by components of the substrate assembly 500 which are mounted on the first region 101R of the substrate 101, such as the light-emitting device 110, the driver 103 (visible in Figure 6A described hereafter).

For example, as shown in Figure 5B, the second metal shielding 534 is larger than the first opening 531 and is positioned to overhang either side of the first opening, and a solder or conductive adhesive 536 positioned on the top wall 530A of the first metal shielding 530 and on edges of the second metal shielding 534 seals the metal shielding assembly. Using a solder or conductive adhesive allows electrically connecting the second metal shielding to the first metal shielding, for example coupling the second metal shielding to the ground through the first metal shielding. This assembling technique is a non-limiting example and other assembling techniques may be contemplated by the person skilled in the art. For example, the second metal shielding may be assembled under the first opening and/or the shape and the dimensions of the second metal shielding may be adjusted to the first opening.

The first metal shielding and the second metal shielding can be coupled or joined to each other by welding, such as laser welding.

The second metal shielding 534 comprises at least a second opening providing an optical path for light emitted by, and optionally transmitted to, the light-emitting device 110. The second metal shielding 534 illustrated in Figures 5A to 5C comprises a plurality of second openings: two second openings 535A, 535B providing optical paths 501, 502 for light emitted respectively by the first light source 111 and the second light source 112, and another second opening 535C allowing the passage of light transmitted to the photodiode 113. Each second opening is dimensioned, for example adjusted, for the optical path to be provided.

As illustrated in Figure 5B, in some embodiments, the first conductive pads 102A on which the light source(s), and optionally the photodiode, are to be positioned are at least partially hidden by the second metal shielding 534 when viewed vertically through the second openings. In other words, a projection of the second openings vertically on the substrate 101 does not entirely contain a footprint of these first conductive pads on the substrate 101.

The metal shielding assembly of Figures 5A to 5C allows more easily mounting, and electrically connecting, the light-emitting device 110, for example the light source(s) and optionally the photodiode, to the substrate 101, before having assembled the second metal shielding 534 to the first metal shielding 530, while limiting the areas of the openings in the metal shielding assembly once the second metal shielding 534 is assembled, the second openings being preferably mainly dedicated to the optical path(s), thus limiting EMI leakage and providing an efficient EMI protection. In addition, the first opening 531 can be easier to machine than the first opening 131 of Figures 1A and 1B.

The second metal shielding 534 may be substantially flat, as shown in Figure 5C, or recessed as shown in Figures 5A and 5B. The recessed form of Figures 5A and 5B allows constricting the size of the second openings 535A, 535B, 535C as it allows positioning these second openings nearer to the light sources 111, 112 and/or light receiving photodiode 113 of the light-emitting device 110, and so provide better EMI shielding.

The first metal shielding 530 of Figures 5A to 5C does not include an EMI absorber layer. In a variant, the first metal shielding 530 and/or the second metal shielding 534 of Figures 5A to 5C may include an EMI absorber layer.

The other features of the substrate assembly 500 of Figures 5A to 5C may be similar to those of the substrate assembly 100 of Figures 1A and 1B. The variants described in relation with the substrate assembly 100 of Figures 1A and 1B may also apply to the substrate assembly 500 of Figures 5A to 5C. The optical sensor module of figures 5A to 5C generally comprises a module cap assembled to the substrate assembly 500, similarly to the optical sensor module of Figures 1A and 1B.

The embodiment of Figures 5A to 5C can advantageously be combined with the embodiment of Figures 3A and 3B, that is, with a glass comprising a conductive trace at least partially covering the second openings of the second metal shielding. The conductive trace is preferably electrically coupled to, for example in contact with, the second metal shielding, and may be coupled to the ground through the second metal shielding.

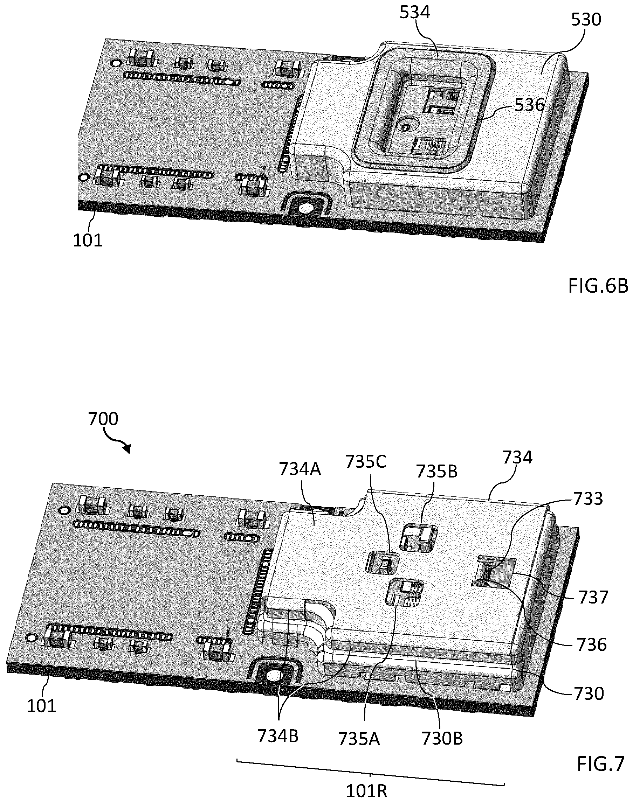

Figure 6A and Figure 6B are top and 3-dimensional views illustrating a variant of the method of Figures 2A to 2D for fabricating the substrate assembly 500 of Figures 5A to 5C.

Figure 6A is a top view of a starting structure which is similar to the structure of Figure 2D, except that the first metal shielding 530 has a larger first opening 531, and that this first opening has a simpler shape. The first and second light sources 111, 112 and the photodiode 113 of the light-emitting device 110 have already been mounted and electrically connected to the substrate 101 through this large first opening 531.

Figure 6B is a 3-dimensional view of a structure obtained after having assembled the second metal shielding 534 to the first metal shielding 530 to cover the first opening 531, for example using a solder or a conductive adhesive 536.

Figure 7 is a 3-dimensional view of substrate assembly 700 for an optical sensor module according to another embodiment.

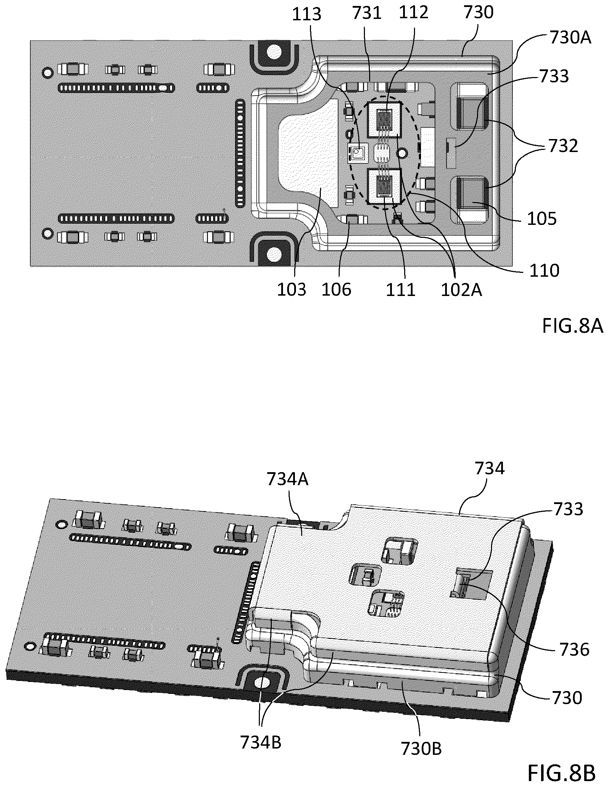

The substrate assembly 700 of Figure 7 mainly differs from that of Figures 1A and 1B in that the first opening 731 (visible in Figure 8A described hereafter) of the first metal shielding 730 is not necessarily adjusted to the dimensions of the light source(s), and optionally of the photodiode, for their mounting on the substrate 101, including the mounting gaps, similarly to that of Figures 5A to 5C. In other words, a trade-off between the EMI protection and the mounting for the first opening is not necessarily searched, and the first opening 731 can have a large area. In addition, the substrate assembly 700 further comprises a second metal shielding 734 adapted to be assembled to the first metal shielding over the first opening 731 once the light-emitting device 110 is mounted and electrically connected to the substrate 101.

The substrate assembly 700 of Figure 7 mainly differs from that of Figures 5A to 5C in that the second metal shielding 734 covers not only the first opening 731, but also the top wall 730A of the first metal shielding 730 (the top wall 730A is visible in Figure 8A described hereafter).

The first metal shielding 730 and the second metal shielding 734 form a metal shielding assembly. For example, the first metal shielding 730 forms a metal frame and the second metal shielding 734 forms a metal cover.

The metal shielding assembly advantageously encircles potential sources of electromagnetic waves emitted by components of the optical sensor module which are mounted on the first region 101R of the substrate 101 such as the light-emitting device 110, the driver 103, the inductors 105 (visible in Figure 8A described hereafter).

In figure 7, the second metal shielding 734 is substantially flat. This is not limiting, and other shapes may be contemplated by the person skilled in the art. For example, in a variant, the second metal shielding may be recessed, or may have a recessed part, for example over the light-emitting device, like the second metal shielding 534 of Figures 5A and 5B.

For example, as represented in Figure 7, the second metal shielding 734 may be assembled to sidewalls 730B of the first metal shielding 730. In more details, the second metal shielding 734 has a top wall 734A having edges 734B that are substantially orthogonally curved and extended with respect the top wall. These edges are conformed to enclose upper edges of at least some of the sidewalls 730B of the first metal shielding 730. The second metal shielding 734 further comprises a fixation tab 736 adapted to cooperate with a slot 733 positioned in the top wall 730A of the first metal shielding 730.

This assembling technique ensures an electrical connection between the second metal shielding 734 and the first metal shielding 730 without for this using a conductive adhesive or solder. Therefore, the second metal shielding 734 may be coupled to the ground through the first metal shielding 730. The assembly of the second metal shielding 734 of Figure 7 may be easier than the assembly of the second metal shielding 534 of Figures 5A to 5C. This assembling technique is a nonlimiting example, and other assembling techniques may be encompassed by the person skilled in the art, with or without using a conductive adhesive or solder. For example, the second metal shielding may comprise clips adapted to be clipped to sidewalls of the first metal shielding, or may be inserted inside, and in contact with the sidewalls of, the first metal shielding, or the second metal shielding may be assembled to the top wall of the first metal shielding.

The top wall 734A of the second metal shielding 734 includes at least a second opening providing an optical path for light emitted by, and optionally transmitted to, the light-emitting device 110. The second metal shielding 734 illustrated in Figure 7 comprises a plurality of second openings: two second openings 735A, 735B providing optical paths for light emitted respectively by the first light source 111 and the second light source 112, and another second opening 735C allowing the passage of light transmitted to the photodiode 113. Each second opening is dimensioned, for example adjusted, for the optical path to be provided.

The top wall 734A of the second metal shielding 734 may further include a third opening 737 adapted to access the fixation tab 736 in order to clip it, and/or for positioning the second metal shielding 734 with respect to the first metal shielding 730.

The top wall 730A of the first metal shielding 730 may further include fourth openings 732, over the inductors 105, as shown in Figure 8A described hereafter, for visual inspection.

In Figure 7, neither the first metal shielding 730, nor the second metal shielding 734, comprises an EMI absorber layer. In a variant, the first metal shielding 730 and/or the second metal shielding 734 of Figure 7 may comprise an EMI absorber layer on its inside top surface.

The embodiment of Figure 7 can be combined with the embodiment of Figures 3A and 3B, that is with a glass comprising a conductive trace at least partially covering the second openings and/or the third opening of the second metal shielding. The conductive trace is preferably electrically coupled to, for example in contact with, the second metal shielding, and may be coupled to the ground through the second metal shielding.

The other features of the substrate assembly 700 of Figure 7 may be similar to those of the substrate assembly 100 of Figures 1A and 1B. The variants described in relation with the substrate assembly 100 of Figures 1A and 1B may also apply to the substrate assembly 700 of Figure 7. The optical sensor module of figure 7 generally comprises a module cap assembled to the substrate assembly 700, similarly to the optical sensor module of Figures 1A and 1B.

In some embodiments, the first conductive pads 102A on which the light source(s), and optionally the photodiode, are to be positioned are at least partially hidden by the second metal shielding 734 when viewed vertically through the second openings. In other words, a projection of the second openings vertically on the substrate 101 does not entirely contain a footprint of these first conductive pads on the substrate 101.

The metal shielding assembly of Figure 7 allows more easily mounting, and electrically connecting, the light-emitting device 110, for example the light source(s) and optionally the photodiode, to the substrate 101, as well as inspecting the surface-mount components before having assembled the second metal shielding 734 to the first metal shielding 730, while limiting the areas of the openings in the metal shielding assembly once the second metal shielding 734 is assembled, the second openings being preferably mainly dedicated to the optical path(s), thus limiting EMI leakage and providing an efficient EMI protection.

Figure 8A and Figure 8B are top and 3-dimensional views illustrating a variant of the method of Figures 2A to 2D for fabricating the substrate assembly 700 of Figure 7.

Figure 8A is a top view of a starting structure which is similar to the structure of Figure 2D, except that the first metal shielding 130 is replaced by the first metal shielding 730 of Figure 7. The first and second light sources 111, 112 and the photodiode 113 of the light-emitting device 110 have already been mounted and electrically connected to the substrate 101 through the large first opening 731. Inductors 105, as well as other SMT components 106, are mounted on the substrate 101 and contained inside the first metal shielding 730.

Figure 8A shows the fourth openings 732 of the first metal shielding 730 over the inductors 105, and the slot 733 adapted to cooperate with the fixation tab 736 of the second metal shielding 734. As illustrated in Figure 8A, the first opening 731 may extend over the driver 103, and also over some of the other SMT components 106, for example for visual inspection.

Figure 8B is a 3-dimensional view of a structure obtained after having assembled, for example clipped, the second metal shielding 734 to the first metal shielding 730, for example by enclosing the curved edges 734B of the second metal shielding around upper edges of sidewalls 730B of the first metal shielding, and by inserting the fixation tab 736 into the slot 733.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. A substrate assembly (100; 300; 500; 700) for an optical sensor module, the substrate assembly comprising:

   - a light-emitting device (110) mounted on a first region (101R) of a substrate (101);
   - a metal shielding assembly comprising a first metal shielding (130; 530; 730) assembled to the substrate over the first region;

   wherein the first metal shielding comprises a first opening (131; 531; 731) providing an optical path for light emitted by the light-emitting device, the first opening being dimensioned such that said light-emitting device can be inserted through said first opening inside said first metal shielding.

2. The substrate assembly (100; 300; 500; 700) according to claim 1, wherein the first metal shielding (130; 530; 730) is dimensioned to surround and at least partially cover the light-emitting device (110), the first metal shielding for example comprising a sidewall (130B; 730B) joined by a top wall (130A; 530A; 730A), the top wall including the first opening (131; 531; 731).

3. The substrate assembly (100; 300; 500; 700) according to claim 1 or 2, wherein the light-emitting device (110) comprises:

   - at least a light source (111, 112), the first opening (131; 531; 731) providing an optical path for light emitted by the at least one light source and being dimensioned such that said at least one light source can be inserted inside said first metal shield and mounted onto the substrate (101) through said first opening; and, optionally,
- a photodiode (113) configured to monitor the light-emitting device, the first opening further providing an optical path for light transmitted to the photodiode, and being further dimensioned such that said photodiode can be inserted inside said first metal shield and mounted onto the substrate through said first opening.

4. The substrate assembly (100; 300; 500; 700) according to any of claims 1 to 3, further comprising a driver (103) mounted on the first region (101R) of the substrate (101), the driver being configured for controlling the light-emitting device (110).

5. The substrate assembly (700) according to claim 4, wherein the first opening (731) extends over the driver (103).

6. The substrate assembly (100; 300; 500; 700) according to any of claims 1 to 5, wherein the first metal shielding (130) is electrically coupled to the substrate (101), for example to a ground trace of the substrate.

7. The substrate assembly (500; 700) according to any of claims 1 to 6, wherein the metal shielding assembly further comprises a second metal shielding (534; 734) assembled to the first metal shielding (530; 730) and at least partially covering the first opening (531; 731), the second metal shielding comprising at least a second opening (535A, 535B, 535C; 735A, 735B, 735C) allowing the passage of light emitted by, and/or transmitted to, the light-emitting device (110), the second metal shielding being for example electrically coupled to, or in contact with, the first metal shielding.

8. The substrate assembly (500) according to claim 7, wherein the second metal shielding (534) includes a recessed part extending inside the metal shielding assembly.

9. The substrate assembly (500) according to claim 7 or 8, wherein the second metal shielding (534) seals the first opening (531).

10. The substrate assembly (700) according to any of claims 7 to 9, wherein the second metal shielding (734) at least partially closes the first metal shielding (730).

11. The substrate assembly (100; 300) according to any of claims 1 to 10, wherein the metal shielding assembly comprises an absorber layer (132) positioned on an inside surface of said metal shielding assembly that faces the light-emitting device (110), for example on an inside surface of the first metal shielding (130) that faces the light-emitting device.

12. The substrate assembly (300) according to any of claims 1 to 11, further comprising a glass (350) including an electrically conductive trace (351) assembled to the first metal shielding (130) over the first opening (131), the conductive trace being for example electrically coupled to, or in contact with, the first metal shielding, for example coupled to a ground trace of the substrate (101) through the first metal shielding.

13. The substrate assembly (100; 300; 500; 700) according to any of claims 1 to 12, wherein the metal of the metal shielding assembly is selected to reflect and/or absorb electromagnetic waves, for example the metal is copper, a copper alloy, a stainless steel, or any electrically conductive material that also has relative magnetic permeability higher than 1.

14. An optical sensor module comprising a substrate assembly according to any of claims 1 to 13, and a module cap assembled to the substrate and adapted to at least partially cover the metal shielding assembly and components which are mounted on the substrate.

15. A method of fabricating a substrate assembly (100; 300; 500; 700) for an optical sensor module, the method comprising:

    - assembling a first metal shielding (130; 530; 730) to a substrate (101) over a first region (101R) of said substrate, the first metal shielding comprising a first opening (131; 531; 731) providing an optical path for light emitted by a light-emitting device (110) to be mounted on the first region; and
    - mounting the light-emitting device (110) to the first region through the first opening.

16. The method of claim 15, further comprising, after the mounting step:

    - assembling a glass (350) including an electrically conductive trace (351) to the first metal shielding (130) over the first opening (131), the conductive trace being for example electrically coupled to, or brought into contact with, the first metal shielding; and/or
    - assembling a second metal shielding (534; 734) to the first metal shielding (530; 730) in order to at least partially cover the first opening (531; 731), the second metal shielding comprising at least a second opening (535A, 535B, 535C; 735A, 735B, 735C) allowing the passage of light emitted by, and/or transmitted to, the light-emitting device (110), the second metal shielding being for example electrically coupled to, or brought into contact with, the first metal shielding.

FIG.1A

AA

FIG.1B

FIG.2A

FIG.2B

FIG.2C

FIG.2D

FIG.3A

FIG.3B

FIG.4

FIG.5A

CC

FIG.5B

FIG.5C

FIG.6A

FIG.6B

FIG.7

FIG.8A

FIG.8B

Europäisches
Patentamt

European
Patent Office

Office européen
des brevets

## EUROPEAN SEARCH REPORT

Application Number

EP 24 20 7128

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/073905 A1 (SHIN OH ELECTRONICS CO LTD [KR]) 15 May 2014 (2014-05-15) * paragraphs [0023], [0025], [0058], [0061]; figures 3, 6 * | 1-16 | INV. G01S7/481 H05K9/00 |
| A | US 2017/181336 A1 (ROBINSON KENNETH M [US] ET AL) 22 June 2017 (2017-06-22) * paragraphs [0021], [0023]; figure 1 * | 11 | |
| A | US 2020/335641 A1 (DUPEYRAT CYRIL [FR] ET AL) 22 October 2020 (2020-10-22) * paragraphs [0044], [0050]; figures 1, 3 * | 12 | |
| A | US 2022/066036 A1 (SHI WEI [US] ET AL) 3 March 2022 (2022-03-03) * paragraph [0076]; figure 6B * | 14,16 | |

TECHNICAL FIELDS
SEARCHED        (IPC)

G01S
H05K

The present search report has been drawn up for all claims

| Place of search | Date of completion of the search | Examiner |
|---|---|---|
| Munich | 6 March 2025 | Kirscher, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

....................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 7128

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2025

| Patent document cited in search report | Publication date | Patent family member(s) | | Publication date |
|---|---|---|---|---|
| WO 2014073905 A1 | 15-05-2014 | CN | 205209633 U | 04-05-2016 |
| | | WO | 2014073905 A1 | 15-05-2014 |
| US 2017181336 A1 | 22-06-2017 | CN | 107114003 A | 29-08-2017 |
| | | US | 2017181336 A1 | 22-06-2017 |
| | | WO | 2016077683 A1 | 19-05-2016 |
| US 2020335641 A1 | 22-10-2020 | CA | 3025328 A1 | 07-12-2017 |
| | | CN | 109769398 A | 17-05-2019 |
| | | EP | 3465759 A1 | 10-04-2019 |
| | | FR | 3051975 A1 | 01-12-2017 |
| | | IL | 263286 A | 06-01-2019 |
| | | JP | 6775608 B2 | 28-10-2020 |
| | | JP | 2019519812 A | 11-07-2019 |
| | | KR | 20190030650 A | 22-03-2019 |
| | | US | 2020335641 A1 | 22-10-2020 |
| | | US | 2021159348 A1 | 27-05-2021 |
| | | WO | 2017207893 A1 | 07-12-2017 |
| US 2022066036 A1 | 03-03-2022 | CN | 114122904 A | 01-03-2022 |
| | | US | 2022066036 A1 | 03-03-2022 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2311561